# EUROPÄISCHE PATENTSCHRIFT

(11) **EP 2 599 368 B1**
(45) Veröffentlichungstag und Bekanntmachung des Hinweises auf die Patenterteilung: **01.08.2018**
(21) Anmeldenummer: 11726709.6
(22) Anmeldetag: 16.06.2011
(51) Int. Cl.: H05K 5/02

(54) **ABDRÜCKVORRICHTUNG UND BEHÄLTNIS MIT EINER SOLCHEN**
FORCING-OFF DEVICE AND CONTAINER COMPRISING SUCH A DEVICE
DISPOSITIF D'ÉJECTION ET BOÎTIER POURVU DUDIT DISPOSITIF

(30) Priorität: 30.07.2010 DE 102010032832
(43) Veröffentlichungstag der Anmeldung: 05.06.2013
(73) Patentinhaber: Eaton Intelligent Power Limited, 4 Dublin (IE)
(72) Erfinder: SAUER, Dieter, 69434 Heddesbach (DE); HIERONYMUS, Frank, 64754 Hesseneck-Schöllenbach (DE); SCHWARZ, Gerhard, 69436 Schönbrunn (DE)
(74) Vertreter: Eaton IP Group EMEA
(86) Internationale Anmeldenummer: PCT/EP2011/002980
(87) Internationale Veröffentlichungsnummer: WO 2012/013267

(56) Entgegenhaltungen:
- EP-A2- 0 048 682
- DE-A1-102005 047 713
- DE-U1-202009 010 039
- US-A1- 2004 117 946

## Beschreibung

Die Erfindung betrifft eine Abdrückvorrichtung eines insbesondere explosionsgeschützten oder flammensicheren Behältnisses. Ein solches Behältnis weist zumindest einen Grundkörper mit einer von einem Öffnungsrand umgebenden Öffnung und einen auf oder in den Öffnungsrand aufsetzbares oder einsetzbares Deckelteil auf.

Solche Behältnisse dienen beispielsweise zur Aufnahme elektronischer Einrichtungen und können als Einzelbehältnisse oder auch gruppenweise angeordnet sein. Deckelteil und Grundkörper werden beispielsweise miteinander verschraubt, um das Deckelteil fest am Grundkörper zu befestigen. Die zwischen Deckelteil und Grundkörper gebildeten Anlageflächen insbesondere im Bereich des Öffnungsrandes sind in der Regel flach ausgebildet und werden durch Auftrag eines Schutzmittels, wie beispielsweise eines Schmiermittels, beispielsweise gegen Korrosion geschützt. Möchte man das Behältnis nach einiger Zeit öffnen, kann dies aufgrund der Adhäsion zwischen Grundkörper und Deckelteil relativ schwierig sein. Das Schutzmittel kann fast die Wirkung eines Klebstoffes haben.

In der Regel wird durch Verwendung eines Werkzeugs versucht einen Spalt zwischen Deckelteil und Grundkörper herzustellen, der dann zum weiteren Öffnen des Behältnisses verwendet wird. Bei entsprechendem Kraftaufwand kann eine Beschädigung von Deckelteil oder Grundkörper insbesondere im Bereich des Öffnungsrandes auftreten, so dass bei einem erneuten Verschließen des Behältnisses nicht mehr gewährleistet ist, dass Explosionsschutz oder Flammensicherheit vorliegt. Dies führt gegebenenfalls zu erhöhten Kosten, zur Reparatur des Behältnisses oder zu einem unsicheren Behältnis.

Aus der Praxis ist bekannt, dass man beispielsweise Werkzeuge zur Herstellung des entsprechenden Spaltes verwendet, die aus einem weicheren Material als das Material des Behältnisses hergestellt sind. Dadurch kann man eine Beschädigung bei der Spaltbildung zwar weitestgehend vermeiden, aber es ist immer noch recht schwierig, das Behältnis zu öffnen.

DE 2009 010 039 U1 offenbart eine elektrische Geräteeinheit mit einem Rahmengehäuse, einem Modulgehäuse und einer Verriegelung, die einen um eine Achse schwenkbaren Betätiger aufweist. Wird der Betätiger in Uhrzeigerrichtung bewegt, wird das Modulgehäuse angehoben. Das Modulgehäuse weist einen Entriegelungszapfen auf, der in entsprechende Führungsnuten des Betätigers eingreift.

EP 0 048 682 A2 beschreibt ein druckfestes Gehäuse mit einem rechteckigen Deckel. Entlang einer entsprechenden Gehäuseöffnung sind Verschlussschienen angeordnet, die den Deckel aufnehmen. Ein Betätigungs- und Lenkhebel bewirkt bei einem Verschwenken ein gleichzeitiges Anheben und seitliches Verschieben des Deckels zum Öffnen.

Der Erfindung liegt daher die Aufgabe zugrunde, eine Abdrückvorrichtung eines entsprechenden Behältnisses bereitzustellen, bei der in einfacher Weise ein öffnen des Behältnisses ohne Beschädigung möglich ist.

Diese Aufgabe wird durch die Merkmale des Patentanspruchs 1 gelöst.

Insbesondere zeichnet sich die Erfindung dadurch aus, dass zumindest in einem Abschnitt in Umfangsrichtung des Behältnisses ein Abdrückabsatz am Grundkörper oder am Deckelteil gebildet ist und wenigstens ein Abdrückteil am Deckelteil oder Grundkörper zwischen einer Abdrückstellung und einer Passivstellung verdrehbar gelagert ist. Das Abdrückteil ist in Abdrückstellung mit dem Abdrückabsatz zur spaltbildenden Beabstandung von Deckelteil und Grundkörper in Anlage.

Erfindungsgemäß besteht die Möglichkeit, dass das Abdrückteil beispielsweise am Deckelteil angeordnet ist, wobei dann der entsprechende Abdrückabsatz am Grundkörper ausgebildet ist. Analog gilt die umgekehrte oder auch eine kombinierte Anordnung, so dass es ebenfalls denkbar ist, ein Abdrückteil am Deckelteil und ein weiteres Abdrückteil am Grundkörper vorzusehen mit jeweils zugehörigen Abdrückabsätzen am jeweils anderen Teil des Behältnisses. Es besteht ebenfalls die Möglichkeit zwei oder mehr Abdrückteile am Deckelteil oder Grundkörper vorzusehen mit jeweils den zugeordneten Abdrückabsätzen am anderen Teil des Behältnisses.

Erfindungsgemäß wird das Abdrückteil aus seiner Passivstellung, in der es nicht in Anlage mit dem Abdrückabsatz ist, in seine Abdrückstellung verdreht. Bei dieser Verdrehung gerät das Abdrückteil mit dem Abdrückabsatz in Kontakt und bei Verdrehung bis in Abdrückstellung drückt sich das Abdrückteil am Abdrückabsatz ab, so dass dadurch eine spaltbildende Beabstandung von Deckelteil und Grundkörper erreicht wird. Die entsprechende Beabstandung von Deckelteil und Grundkörper ist dann zumindest so groß, dass durch manuelle Einwirkung auf das Deckelteil oder durch Verwendung weiterer Werkzeuge anschließend ein relativ einfaches Trennen von Deckelteil und Grundkörper möglich ist. Zumindest die anfängliche Adhäsion, siehe die obige Beschreibung, wird durch die spaltbildende Beabstandung überwunden, da Deckelteil und Grundkörper zumindest durch den Spalt voneinander getrennt sind.

Durch entsprechende Ausbildung von Abdrückteil und Abdrückabsatz kann die Beabstandung je nach Erfordernis vorgegeben werden.

Der entsprechende Abdrückabsatz kann Teil eines insgesamt in Umfangsrichtung umlaufenden Absatzes sein. Beispielsweise kann der Öffnungsrand einen solchen umlaufenden Absatz aufweisen. Es besteht ebenfalls die Möglichkeit, dass am Grundkörper ein solcher umlaufender Absatz mit dem Abdrückabsatz ausgebildet ist.

Es ist denkbar, dass der Abdrückabsatz vom jeweiligen Teil des Behältnisses über entsprechende Seitenflächen nach außen vorsteht. In diesem Zusammenhang kann ebenfalls das Abdrückteil nach außen vorstehend am jeweils anderen Teil des Behältnisses verdrehbar gelagert sein. Bevorzugt kann eine Ausführungsform sein, bei der das Abdrückteil in einer seitlichen Ausnehmung vom Grundkörper oder Deckelteil verdrehbar gelagert ist. Auf diese Weise steht das Abdrückteil nicht seitlich aus dem entsprechenden Teil des Behältnisses vor, so dass es relativ geschützt angeordnet ist. Analog kann auch der entsprechende Abdrückabsatz im Bereich dieser seitlichen Ausnehmung zur Anordnung des Abdrückteils ausgebildet sein und insbesondere nur im Bereich der seitlichen Ausnehmung nach außen vorstehen.

Um in einfacher Weise einen Kontakt zwischen Abdrückteil und Abdrückabsatz realisieren zu können, kann die seitliche Ausnehmung zumindest in Richtung Abdrückabsatz geöffnet sein. Durch entsprechende Drehung des Abdrückteils kann dieses durch die Öffnung hervortreten und dann in seiner Abdrückstellung durch entsprechenden Kontakt mit dem Abdrückabsatz die spaltbildende Beabstandung herstellen.

Zur Verdrehung des Abdrückteils wird in der Regel ein Werkzeug, wie ein Schraubendreher oder dergleichen verwendet. Um diesen in einfacher Weise in Kontakt mit dem Abdrückteil zu bringen, kann die seitliche Ausnehmung eine in Richtung einer Kante von Deckelteil oder Grundkörper offene Eingriffsvertiefung aufweisen. Über diese Eingriffsvertiefung kann das entsprechende Werkzeug mit dem Abdrückteil in Kontakt und in Eingriff gebracht werden, so dass das Abdrückteil mittels des Werkzeuges dann zwischen Passiv- und Abdrückstellung verdrehbar ist.

Dabei ist die entsprechende Eingriffsvertiefung in Verdrehrichtung zumindest so groß, dass ein ausreichendes Verdrehen des Abdrückteils zwischen Passiv- und Abdrückstellung durch das entsprechende Werkzeug möglich ist.

Das Abdrückteil kann in unterschiedlicher Weise ausgebildet sein. Denkbar ist ein hebelartiges Abdrückteil, von dem ein Hebelarm mit dem entsprechenden Werkzeug in Eingriff bringbar ist, während der andere Hebelarm durch entsprechende Verdrehung des Abdrückteils mit dem Abdrückabsatz in Kontakt bringbar ist.

Bei einem bevorzugten Ausführungsbeispiel kann das Abdrückteil eine Exzenterscheibe sein.

Um einen Eingriff zwischen entsprechendem Werkzeug und Abdrückteil in einfacher Weise zu ermöglichen, kann das Abdrückteil eine im Wesentlichen in Richtung Eingriffsvertiefung weisende Eingriffsöffnung aufweisen. In diese Eingriffsöffnung ist das Werkzeug von der Eingriffsvertiefung her teilweise einsteckbar und anschließend ist das Abdrückteil dann durch das Werkzeug zwischen den entsprechenden Stellungen verdrehbar.

Je nach verwendetem Werkzeug kann die Eingriffsöffnung entsprechend ausgebildet sein. Wird beispielsweise ein Schraubendreher verwendet, kann die Eingriffsöffnung schlitzförmig ausgebildet sein.

Um sowohl die Passivstellung festzulegen, als auch ein Einstecken des entsprechenden Werkzeuges zu vereinfachen, kann die Eingriffsöffnung einen in Richtung Eingriffsvertiefung vorstehenden Führungsvorsprung aufweisen. Dieser steht einseitig von der Eingriffsöffnung vor und kann als Führungsanschlag verwendet werden.

In Passivstellung kann außerdem der entsprechende Führungsvorsprung mit einem Begrenzungsrand der Eingriffsöffnung in Anlage sein, wodurch die Passivstellung festgelegt ist.

Vorteilhafterweise ist ein entsprechendes Abdrückteil nahe einer Kante des Behältnisses angeordnet, um in diesem Bereich Deckelteil und Grundkörper zu trennen. Ein entsprechendes Abdrückteil kann zumindest auf jeder Seite des Behältnisses im Bereich einer solchen Kante angeordnet sein.

Um ein Vorstehen des Abdrückteils nach außen zu verhindern, kann das Abdrückteil in einem seitlich umlaufenden Deckelrand des Deckelteils insbesondere versenkt angeordnet sein. Dies gilt analog für eine Anordnung des Abdrückteils im Grundkörper.

Die Erfindung betrifft ebenfalls ein entsprechendes Behältnis mit zumindest einer Abdrückvorrichtung, wie sie vorstehend beschrieben wurde.

Im Folgenden werden vorteilhafte Ausführungsbeispiele der Erfindung anhand der in der Zeichnung beigefügten Figuren näher beschrieben.

Es zeigen:
- Figur 1: eine perspektivische Ansicht eines Behältnisses mit einem Ausführungsbeispiel einer Abdrückvorrichtung gemäß Erfindung;
- Figur 2: eine Draufsicht auf das Behältnis nach Figur 1, und
- Figur 3: eine Seitenansicht des Behältnisses nach Figur 1 mit Abdrückvorrichtung auf dieser Seite

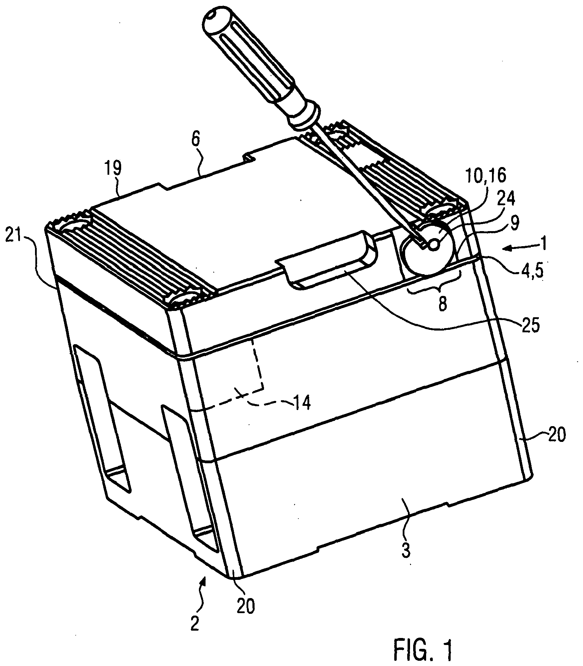

Figur 1 zeigt eine perspektivische Seitenansicht einer Abdrückvorrichtung 1 eines Behältnisses 2. Das Behältnis 2 umfasst einen in etwa quaderförmigen Grundkörper 3. An dessem oberen Ende weist der Grundkörper 3 eine Öffnung 5 auf, die von einem Öffnungsrand 4 umgeben ist. Auf die Öffnung 5 beziehungsweise den Öffnungsrand 4 ist ein Deckelteil 6 lösbar aufgesetzt. Das Deckelteil 6 weist zwei Griffmulden 25 sowie einen in Richtung Grundkörper 3 vorstehenden Deckelrand 21 auf.

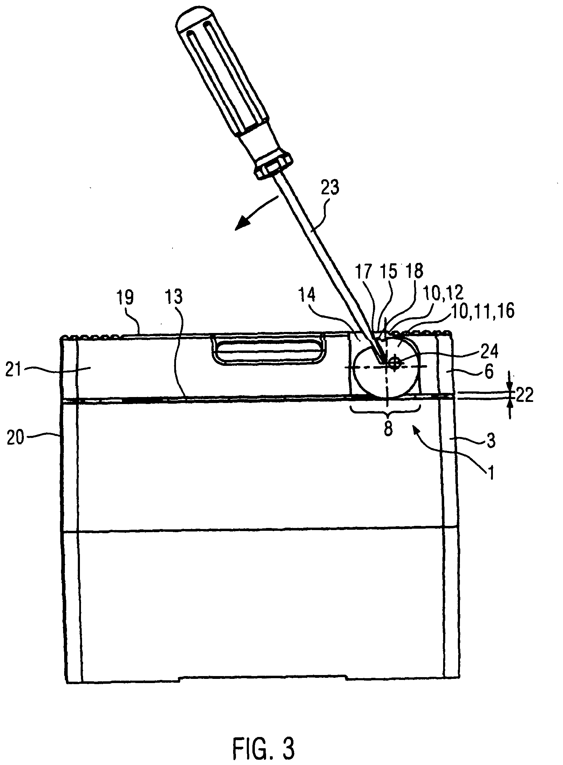

Je nach Ausführungsbeispiel wird der Öffnungsrand 4 des Grundkörpers 3 von dem Deckelrand 21 des Deckelteils 6 übergriffen, siehe hierzu Figur 1, oder aber der Deckelrand 21 wird in den Öffnungsrand 4 eingesetzt. Der entsprechend innen befindliche Öffnungsbeziehungsweise Deckelrand weist einen nach außen vorstehenden Absatz 13 auf, siehe auch Figur 3, der als flache Anlagefläche für den Rand des entsprechenden anderen Teils dient. Zwischen den Rändern ist in der Regel ein Dicht- oder Korrosionsschutzmittel aufgetragen, wie beispielsweise ein Schmierstoff. Durch die enge und flache Anlage der entsprechenden Ränder und durch die explosionsgeschützte und flammensichere Ausführung des Behältnisses ergeben sich beim Lösen des Deckelteils 6 in einigen Fällen Probleme.

Um das Deckelteil 6 in einfacher Weise zumindest einen Teil gegenüber dem Grundkörper 3 abzuheben, weist das Behältnis 2 die Abdrückvorrichtung 1 auf.

Diese ist bei dem dargestellten Ausführungsbeispiel im Bereich einer Kante des Behältnisses 2 im Deckelrand 21 angeordnet. Die Abdrückvorrichtung 1 umfasst ein verdrehbares Abdrückteil 10 in Form einer Exzenterscheibe 16. Diese ist exzentrisch an einer Drehachse 24 drehbar gelagert. Die Exzenterscheibe 16 ist in einer Ausnehmung 14 des Deckelrandes 21 angeordnet. Dadurch ist die Exzenterscheibe 16 versenkt in dieser Ausnehmung 14 angeordnet und steht nicht nach außen über den Deckelrand vor. Die Ausnehmung 14 weist an ihrer Oberseite eine Eingriffsvertiefung 15 auf. Über diese ist ein Werkzeug 23, siehe auch Figur 3, wie beispielsweise ein Schraubendreher, in die Ausnehmung 14 einführbar. Zur Drehverbindung des Werkzeugs mit dem Abdrückteil 10 weist dieses eine Eingriffsöffnung 17 auf, die in Richtung Eingriffsvertiefung 15 weist. Die Eingriffsöffnung 17 ist schlitzförmig zum Einsetzen eines freien Endes des Werkzeugs 23 ausgebildet. Zumindest einseitig weist die schlitzförmige Eingriffsöffnung 17 einen in Richtung Werkzeug 23 vorstehenden Führungsvorsprung 18 auf. Dieser dient sowohl zur seitlichen Anlage an das Werkzeug 23, wie auch zur Festlegung einer Passivstellung 12 des Abdrückteils 10, siehe Figur 3. In dieser Passivstellung liegt der Führungsvorsprung 18 an einem Rand der Eingriffsvertiefung 15 an.

In Figuren 1 und 3 ist das Abdrückteil 10 in seine Abdrückstellung 11 verschwenkt. Dadurch ist das Abdrückteil 10 mit einem Abdrückabsatz 9 in Anlage, der Teil des Absatzes 13 ist. In dieser Abdrückstellung 11 ist ein Spalt 22 zwischen unterem Ende des Deckelteils 6 und dem Absatz 13 des Grundkörpers 3 gebildet. Durch diesen Spalt erfolgt eine bereits teilweise Trennung von Deckelteil 6 und Grundkörper 3, die eine erste Adhäsion dieser beiden Teile aneinander überwindet und ein anschließendes Abziehen des Deckelteils 6 erleichtert.

Der entsprechende Abdrückabsatz 9 ist in einem Abschnitt 8 des Absatzes 13 ausgebildet. In diesem Abschnitt 8 ist die Ausnehmung 14 in Richtung zum Abdrückabsatz 9 offen. Dadurch kann bei entsprechender Verdrehung des Abdrückteils 10 dieses aus der Ausnehmung 14 in Richtung Abdrückabsatz 9 vorstehen und bei entsprechender Verdrehung bis in die Abdrückstellung 11 den Spalt 22 zwischen Deckelteil 6 und Grundkörper 3 bilden.

In Figur 1 ist gestrichelt eine weitere Ausnehmung 14 dargestellt, die im Bereich einer Kante 20 des Grundkörpers 3 angeordnet ist. Es besteht die Möglichkeit, dass in einer solchen Ausnehmung 14 ein entsprechendes Abdrückteil 10 verdrehbar gelagert ist und gegen einen entsprechenden Abdrückabsatz 9 am Deckelteil 6 bei Verdrehung aus Passivstellung 12 in Abdrückstellung 11 drückt und dadurch einen entsprechenden Spalt 22 bildet.

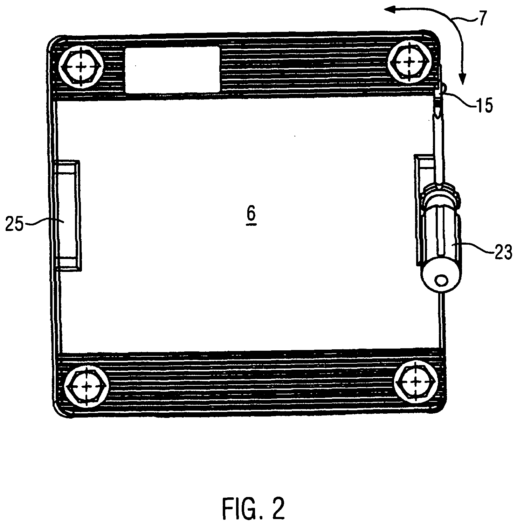

Es besteht weiterhin die Möglichkeit, mehrere solcher Abdrückvorrichtungen 1 beispielsweise entlang einer Umfangsrichtung 7, siehe auch Figur 2, des Behältnisses vorzugsweise im Bereich von Kanten 19 beziehungsweise 20 anzuordnen. Von der jeweiligen Kante her erfolgt der Eingriff des entsprechenden Werkzeugs 23, siehe auch Figuren 1 und 3.

In Figur 2 ist das Behältnis 2 nach Figur 1 in einer Draufsicht dargestellt. Insbesondere erkennbar ist das Werkzeug 23 in einer schrägen Stellung, in der das Abdrückteil 10 in die Abdrückstellung 11 verdreht ist. Ansonsten wird hinsichtlich der Beschreibung der Abdrückvorrichtung und des Behältnisses auf die Figuren 1 und 3 verwiesen.

Figur 3 zeigt eine Seitenansicht des Behältnisses 2 mit im Bereich des Deckelrandes 21 angeordneter Abdrückvorrichtung 1. Die Abdrückvorrichtung 1 ist analog zu Figur 1 dargestellt, wobei das Abdrückteil 10 bereits in entsprechender Abdrückstellung 11 angeordnet ist. In im Wesentlichen vertikaler Stellung des Werkzeuges 23 nach Figur 3 ist das Abdrückteil 10 in seiner Passivstellung 12 angeordnet, siehe auch die gestrichelte Darstellung in Figur 3.

In einer solchen Passivstellung 12 liegt der Führungsvorsprung 18 seitlich an einer Kante der Eingriffsvertiefung 15 an. In Passivstellung 12 sind Deckelteil 6 und Grundkörper 3 ohne Bildung eines Spaltes miteinander in Eingriff.

In Figur 3 ist insbesondere der in Umfangsrichtung 7, siehe auch Figur 2, umlaufende Absatz 13 erkennbar, von dem der entsprechende Abdrückabsatz 9 ein Teil ist.

Im Übrigen wird auf die vorangehende Beschreibung verwiesen.

Die Erfindung betrifft ebenfalls ein entsprechendes Behältnis 2 mit zumindest einer Abdrückvorrichtung 1, wie sie im Vorangehenden beschrieben wurde.

Ein solches Behältnis 2 kann als Einzelbehältnis oder auch als integriertes Behältnis eines elektrischen Betriebsmittels oder im Zuge einer elektrischen Verteilung verwendet werden.

Durch die Erfindung lässt sich zumindest teilweise ein entsprechendes Deckelteil vom Grundkörper in einfacher Weise trennen, ohne dass mit einem Werkzeug direkt ein Spalt zwischen Deckelteil und Grundkörper erzeugt werden muss.

## Patentansprüche

1. Abdrückvorrichtung (1) eines insbesondere explosionsgeschützten oder flammensicheren Behältnisses (2) für elektronische Einrichtungen, welches zumindest einen Grundkörper (3) mit einer von einem Öffnungsrand (4) umgebenden Öffnung (5) und einen auf oder in den Öffnungsrand aufsetzbares oder einsetzbares Deckelteil (6) aufweist, wobei zumindest in einem Abschnitt (8) in Umfangsrichtung (7) des Behältnisses (2) ein Abdrückabsatz (9) am Grundkörper (3) oder Deckelteil (6) gebildet ist, wobei der Abdrückabsatz ein Teil eines den Öffnungsrand (4) umlaufenden Absatzes (13) ist, und wobei wenigstens ein Abdrückteil (10) in einer seitlichen Ausnehmung (14) am Deckelteil (6) oder am Grundkörper (3) zwischen einer Abdrückstellung (11) und einer Passivstellung (12) exzentrisch verdrehbar gelagert ist, wobei das Abdrückteil (10) als Exzenterscheibe ausgebildet ist und in Abdrückstellung (11) mit dem Abdrückabsatz (9) in Kontakt gerät, so dass eine spaltbildende Beabstandung von Deckelteil (6) und Grundkörper (3) erreicht wird.

2. Abdrückvorrichtung nach Anspruch 1,
**dadurch gekennzeichnet,**
**dass** die seitliche Ausnehmung (14) zumindest in Richtung Abdrückabsatz (9) geöffnet ist.

3. Abdrückvorrichtung nach einem der Ansprüche 1 oder 2,
**dadurch gekennzeichnet,**
**dass** die seitliche Ausnehmung (14) eine in Richtung einer Kante (19, 20) von Deckelteil (6) oder Grundkörper (3) offene Eingriffsvertiefung (15) aufweist.

4. Abdrückvorrichtung nach Anspruch 3, **dadurch gekennzeichnet, dass** das Abdrückteil (10) eine in Richtung Eingriffsvertiefung (15) weisende Eingriffsöffnung (17) aufweist.

5. Abdrückvorrichtung nach Anspruch 4,
**dadurch gekennzeichnet,**
**dass** die Eingriffsöffnung (17) schlitzförmig ist.

6. Abdrückvorrichtung nach einem der Ansprüche 4 oder 5,
**dadurch gekennzeichnet,**
**dass** die Eingriffsöffnung (17) als Sackloch ausgebildet ist.

7. Abdrückvorrichtung nach einem der Ansprüche 4 bis 6,
**dadurch gekennzeichnet,**
**dass** die Eingriffsöffnung (17) einen in Richtung Eingriffsvertiefung (15) vorstehenden Führungsvorsprung aufweist.

8. Abdrückvorrichtung nach einem der vorangehenden Ansprüche,
**dadurch gekennzeichnet,**
**dass** das Abdrückteil (10) in einem seitlich umlaufenden Deckelrand (21) des Deckelteils (6) insbesondere versenkt angeordnet ist.

9. Behältnis (2) mit zumindest einer Abdrückvorrichtung (1) nach einem der vorangehenden Ansprüche.

## Claims

1. Forcing-off device (1) of a container (2) for electronic devices, in particular an explosion-proof or flameproof container, the container comprising at least one base body (3) with an opening (5) surrounded by an opening edge (4) and a cover part (6) that can be placed onto or inserted into the opening edge, wherein a forcing-off shoulder (9) is formed on the base body (3) or the cover part (6), at least in a section (8) in a circumferential direction (7) of the container (2), wherein the forcing-off shoulder is part of a shoulder (13) running around the opening edge (4), and wherein at least one forcing-off part (10) is rotatably mounted in a lateral recess (14) on the cover part (6) or on the base body (3), in an eccentric fashion between a forcing-off position (11) and a passive position (12), wherein the forcing-off part (10) is formed as an eccentric disc and in the forcing-off position (11) is in abutment with the forcing-off shoulder (9), to achieve a gap-forming spacing of the cover part (6) and the base body (3).

2. Forcing-off device according to claim 1,
**characterised in that**
the lateral recess (14) is opened at least in the direction of the forcing-off shoulder (9).

3. Forcing-off device according to any of claims 1 or 2,
**characterised in that**
the lateral recess (14) has an engagement depression (15) which is open towards an edge (19, 20) of the cover part (6) or the base body (3).

4. Forcing-off device according to claim 3,
**characterised in that**
the forcing-off part (10) comprises an engagement opening (17) oriented in the direction of the engagement depression (15).

5. Forcing-off device according to claim 4,
**characterised in that**
the engagement opening (17) is slit-shaped.

6. Forcing-off device according to any of claims 4 or 5,
**characterised in that**
the engagement opening (17) is configured as a blind hole.

7. Forcing-off device according to any of claims 4 to 6,
**characterised in that**
the engagement opening (17) comprises a guide projection protruding in the direction of the engagement depression (15).

8. Forcing-off device according to any of the preceding claims,
**characterised in that**
the forcing-off part (10) is arranged, in particular countersunk, in a laterally surrounding cover edge (21) of the cover part (6).

9. Container (2) with at least one forcing-off device (1) according to any of the preceding claims.

## Revendications

1. Dispositif d'éjection (1) d'un boîtier (2) en particulier protégé contre les explosions et ignifuge pour dispositifs électroniques, qui présente au moins un corps de base (3) avec une ouverture (5) entourée d'un rebord d'ouverture (4) et une partie de couvercle (6) qui peut être appliquée sur le rebord d'ouverture ou insérée dans celui-ci ;
dans lequel est formé, au moins dans une section (8) dans la direction périphérique (7) du boîtier (2), un palier d'éjection (9) sur le corps de base (3) ou la partie de couvercle (6), dans lequel le palier d'éjection fait partie d'un palier (13) faisant tourner le rebord d'ouverture (4) et dans lequel au moins une partie d'éjection (10) est montée à rotation dans une cavité latérale (14) sur la partie de couvercle (6) ou sur le corps de base (3) entre une position d'éjection (11) et une position passive (12) de manière excentrique, dans lequel la partie d'éjection (10) est conçue en disque d'excentrique et est en contact avec le palier d'éjection (9) en position d'éjection (11) de sorte que soit formée une séparation de clivage de la partie de couvercle (6) et du corps de base (3).

2. Dispositif d'éjection selon la revendication 1,
**caractérisé en ce que**
la cavité latérale (14) est ouverte au moins dans la direction du palier d'éjection (9).

3. Dispositif d'éjection selon l'une quelconque des revendications 1 ou 2,
**caractérisé en ce que**
la cavité latérale (14) présente un renfoncement d'engagement (15) ouvert dans la direction d'une arête (19, 20) de la partie de couvercle (6) ou du corps de base (3).

4. Dispositif d'éjection selon la revendication 3, **caractérisé en ce que** la partie d'éjection (10) présente une ouverture d'engagement (17) tournée dans la direction du renfoncement d'engagement (15).

5. Dispositif d'éjection selon la revendication 4,
**caractérisé en ce que**
l'ouverture d'engagement (17) est en forme de fente.

6. Dispositif d'éjection selon l'une quelconque des revendications 4 ou 5,
**caractérisé en ce que**
l'ouverture d'engagement (17) se présente sous la forme d'un trou borgne.

7. Dispositif d'éjection selon l'une quelconque des revendications 4 à 6,
**caractérisé en ce que**
l'ouverture d'engagement (17) présente une saillie de guidage qui dépasse dans la direction du renfoncement d'engagement (15).

8. Dispositif d'éjection selon l'une quelconque des revendications précédentes,
**caractérisé en ce que**
la partie d'éjection (10) est agencée dans un rebord (21) de la partie de couvercle (6) circulant latéralement, en particulier à fleur.

9. Boîtier (2) doté d'un dispositif d'éjection (1) selon l'une quelconque des revendications précédentes.
